(19) Europäisches Patentamt
European Patent Office
Office européen des brevets

(11) **EP 3 202 044 B1**

(12) **FASCICULE DE BREVET EUROPEEN**

(45) Date de publication et mention
de la délivrance du brevet:
**18.03.2020 Bulletin 2020/12**

(21) Numéro de dépôt: **15767494.6**

(22) Date de dépôt: **24.09.2015**

(51) Int Cl.:
*H03M 7/30* (2006.01)   *G06T 9/00* (2006.01)
*G06F 7/48* (2006.01)

(86) Numéro de dépôt international:
**PCT/EP2015/071939**

(87) Numéro de publication internationale:
**WO 2016/050595 (07.04.2016 Gazette 2016/14)**

(54) **PROCEDE DE CODAGE D'UN SIGNAL REEL EN UN SIGNAL QUANTIFIE**

VERFAHREN ZUR CODIERUNG EINES REALEN SIGNALS IN EIN QUANTISIERTES SIGNAL

METHOD OF CODING A REAL SIGNAL INTO A QUANTIZED SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.10.2014 FR 1459470**

(43) Date de publication de la demande:
**09.08.2017 Bulletin 2017/32**

(73) Titulaire: **Commissariat à l'Énergie Atomique et aux Énergies Alternatives**
**75015 Paris (FR)**

(72) Inventeurs:
• **TRINH, Hong-Phuc**
**F-91300 Massy (FR)**
• **DURANTON, Marc**
**F-91400 Orsay (FR)**
• **PAINDAVOINE, Michel**
**F-21370 Plombières les Dijon (FR)**

(74) Mandataire: **Hammes, Pierre et al**
**Marks & Clerk France**
**Immeuble Visium**
**22, avenue Aristide Briand**
**94117 Arcueil Cedex (FR)**

(56) Documents cités:
**US-A1- 2012 002 895     US-A1- 2012 002 895**

• **Vincent Vanhoucke ET AL: "Improving the speed of neural networks on CPUs", , 17 décembre 2011 (2011-12-17), XP055175306, Extrait de l'Internet: URL:https://deeplearningworkshopnips2011.files.wordpress.com/2011/12/8.pdf [extrait le 2015-03-10]**
• **JIANG M ET AL: "THE EFFECTS OF QUANTIZATION ON MULTI-LAYER FEEDFORWARD NEURAL NETWORKS", INTERNATIONAL JOURNAL OF PATTERN RECOGNITION AND ARTIFICIAL INTELLIGENCE (IJPRAI), WORLD SCIENTIFIC PUBLISHING, SI, vol. 17, no. 4, 1 juin 2003 (2003-06-01), pages 637-661, XP001171799, ISSN: 0218-0014, DOI: 10.1142/S0218001403002514**
• **Vincent Vanhoucke ET AL: "Improving the speed of neural networks on CPUs", , 17 December 2011 (2011-12-17), XP055175306, Retrieved from the Internet: URL:https://deeplearningworkshopnips2011.files.wordpress.com/2011/12/8.pdf [retrieved on 2015-03-10]**

**Description**

L'invention concerne le domaine des applications de traitement de signaux et de traitement de données, implémentés par des processeurs logiciels et/ou matériels aux ressources de calcul limitées. L'invention concerne toutes les applications de traitement de signaux qui nécessitent l'exécution d'opérations de multiplication d'addition ou de convolution. En particulier, l'invention vise les applications temps-réelles qui requièrent l'exécution d'un grand nombre d'opérations en un temps limité.

L'invention porte plus précisément sur un procédé de codage d'un signal représenté en notation réelle en un signal quantifié dont les échantillons sont représentés en notation à virgule fixe afin de limiter le coût calculatoire à effectuer sur ces nombres ainsi que la place mémoire nécessaire pour les stocker.

L'invention s'applique notamment aux applications de traitement d'image, traitement vidéo et en particulier aux algorithmes dits réseaux de neurones qui requièrent une grande capacité de stockage pour sauvegarder les poids synaptiques et un grand nombre d'opérations, en particulier de convolutions.

Les réseaux de neurones sont par exemple utilisés dans les domaines de la reconnaissance ou la classification d'images, par exemple pour des panneaux de signalisation, pour l'indexation de grandes bases de données d'image, pour la reconnaissance des codes postaux sur une enveloppe ou plus généralement pour la reconnaissance de caractères alphanumériques.

Mais l'invention s'applique également à toute autre application qui nécessite l'emploi d'un processeur et d'une mémoire de stockage afin de réaliser des opérations sur des signaux échantillonnés numériquement. Les signaux visés peuvent être des signaux image, vidéo, audio, mais aussi des signaux radiofréquences.

Le problème visé par l'invention consiste à quantifier un signal réel sur un nombre de bits le plus faible possible afin de limiter les ressources nécessaires pour stocker les échantillons de signal et réaliser les opérations mathématiques avec une réalisation la plus simple possible en matière de matériel nécessaires aux traitements visés. En particulier, l'invention vise à permettre une simplification dans la structure de réalisation d'une multiplication de deux nombres réels.

Mais la quantification du signal doit également permettre de ne pas dégrader les performances et la précision des traitements appliqués sur les signaux.

La littérature du domaine des réseaux de neurone comporte des enseignements concernant les solutions possibles pour réduire la complexité des traitements réalisés dans le cadre de ce type d'applications.

La référence [1] présente une optimisation des opérations de multiplication et d'autres opérations non linéaires utilisées dans les traitements exécutés par les réseaux de neurones. L'optimisation envisagée consiste à effectuer une approximation linéaire d'un nombre entier. Par exemple le nombre $2^x$ est approximé par $2^{int(x)}(1+frac(x))$, où $int(x)$ désigne la partie entière du nombre réel x et $frac(x)$ désigne sa partie fractionnaire. L'implémentation d'une multiplication de deux nombres approximés par cette représentation ne nécessite que l'emploi de registres à décalage et d'additionneurs. Cependant l'opération de multiplication reste complexe à mettre en œuvre.

La référence [2] propose d'utiliser une représentation approximée de l'opération exacte de multiplication en introduisant un multiplieur logarithmique itératif. Cependant le nombre de bits utilisé pour la quantification des nombres réels n'est pas optimisé.

La référence [3] présente plusieurs représentations des valeurs des signaux réels pour l'optimisation des opérations utilisées dans les traitements exécutées par le réseaux de neurones.

L'invention propose de résoudre les limitations des solutions de l'art antérieur en proposant une méthode de quantification d'un signal réel qui utilise une approximation particulière et qui permet de simplifier l'implémentation de l'opération de multiplication de deux nombres réels.

L'invention a ainsi pour objet un procédé, mis en œuvre par un processeur, de codage d'un signal réel, par exemple un signal image, en un signal quantifié, ledit procédé comprenant les étapes suivantes appliquées à chaque échantillon réel dudit signal réel :

- Convertir l'échantillon réel dans une représentation numérique en un échantillon binarisé comportant une partie fractionnaire
- Sélectionner, dans la partie fractionnaire du nombre, un nombre N prédéterminé de bits non nuls les plus significatifs,
- pour chaque bit i significatif non nul sélectionné, i variant de 1 à N, déterminer sa distance $P_i$ par rapport au bit significatif non nul sélectionné voisin de rang supérieur ou, pour le premier bit significatif non nul sélectionné, par rapport à la virgule,
- retrancher de ladite distance $P_i$ la plus petite valeur possible de distance entre deux bits non nuls dans un nombre binarisé quelconque converti dans ladite représentation numérique
- coder la distance modifiée $P_i$ sur un nombre $M_i$ de bits prédéterminé.

Selon un aspect particulier, le procédé de codage d'un signal réel en un signal quantifié selon l'invention comprend une étape préalable de transformation de l'échantillon réel en un nombre réel compris strictement entre - 1 et 1.

Selon un aspect particulier de l'invention, la représentation numérique est une représentation binaire ou une représentation ternaire balancée dans laquelle un signe +/- est associé à chaque bit, ledit signe étant codé par un bit dans le signal quantifié. Pour ces représentations, la valeur minimale de distance entre deux bits non nuls est égale à un.

Selon un autre aspect particulier de l'invention, la représentation numérique est une représentation binaire signée canonique qui vérifie les propriétés suivantes :

- Deux bits consécutifs de la représentation binaire signée canonique d'un nombre ne sont jamais simultanément non nuls,
- La représentation binaire signée canonique d'un nombre est unique,
- La représentation binaire signée canonique d'un nombre comporte un nombre minimum de bits non nuls.

Pour une représentation binaire signée canonique, la valeur minimale de distance entre deux bits non nuls est égale à deux.

Selon un aspect particulier, le procédé de codage d'un signal réel en un signal quantifié selon l'invention comprend en outre les étapes suivantes (105) :

- Si la distance modifiée $P_i$, associée au bit significatif non nul d'indice i, présente une valeur supérieure ou égale à $2^{M_i} - 1$, où $M_i$ est le nombre de bits choisi pour coder la distance modifiée $P_i$, décomposer la valeur de la distance modifiée en une somme de $2^{M_i} - 1$ et d'une valeur résiduelle $P'_{i+1}$,
- Coder le terme $2^{M_i} - 1$ sur le nombre de bits $M_i$ choisi pour coder la distance modifiée $P_i$,
- Effectuer les substitutions suivantes : $P_N = P_{N-1}$, ..., $P_{i+2} = P_{i+1}$, $P_{i+1} = P'_{i+1}$

Selon un aspect particulier de l'invention, le signal est un signal image ou un signal composé de poids synaptiques d'un réseau de neurones.

L'invention a également pour objet un dispositif de codage d'un signal réel, par exemple un signal vidéo, en un signal quantifié, comprenant un module configuré pour exécuter le procédé selon l'invention et un programme d'ordinateur comportant des instructions pour l'exécution du procédé de codage d'un signal réel par exemple un signal vidéo, en un signal quantifié, selon l'invention, lorsque le programme est exécuté par un processeur.

L'invention a également pour objet un circuit multiplieur configuré pour calculer le résultat de la multiplication d'un premier nombre avec un second nombre quantifiés par application du procédé de codage selon l'invention avec un nombre N de distances égal à deux, ledit circuit comprenant un additionneur agencé pour additionner la première distance du premier nombre quantifié avec la première distance du second nombre quantifié, une table de correspondance indexée au moins par les valeurs de la seconde distance du premier nombre quantifié et de la seconde distance du second nombre quantifié et un registre à décalage configuré pour réaliser un décalage binaire sur la sortie de la table de correspondance d'un nombre de bits égal à la sortie de l'additionneur.

Selon un aspect particulier du circuit multiplieur selon l'invention, la table de correspondance est en outre indexée par le signe de la seconde distance du premier nombre quantifié et le signe de la seconde distance du second nombre quantifié, ledit circuit multiplieur comprenant en outre une porte logique OU exclusif recevant en entrée le signe de la première distance du premier nombre quantifié et le signe de la première distance du second nombre quantifié.

L'invention a encore pour objet un circuit de convolution configuré pour calculer le résultat de la convolution entre un premier vecteur de nombres et un second vecteur de nombres quantifiés par application du procédé de codage selon l'invention, ledit circuit de convolution comprenant un circuit multiplieur selon l'invention et un accumulateur configuré pour accumuler les valeurs de sortie du circuit multiplieur.

D'autres caractéristiques et avantages de la présente invention apparaîtront mieux à la lecture de la description qui suit en relation aux dessins annexés qui représentent :

- La figure 1, un organigramme illustrant les étapes de mise en œuvre du procédé de codage selon l'invention
- La figure 2, un exemple illustratif d'application du procédé à un nombre réel en représentation binaire
- La figure 3, un exemple illustratif d'application du procédé à un nombre réel en représentation binaire signée canonique,
- La figure 4, un schéma d'un circuit de convolution adapté pour réaliser la convolution de nombres quantifiés selon l'invention.

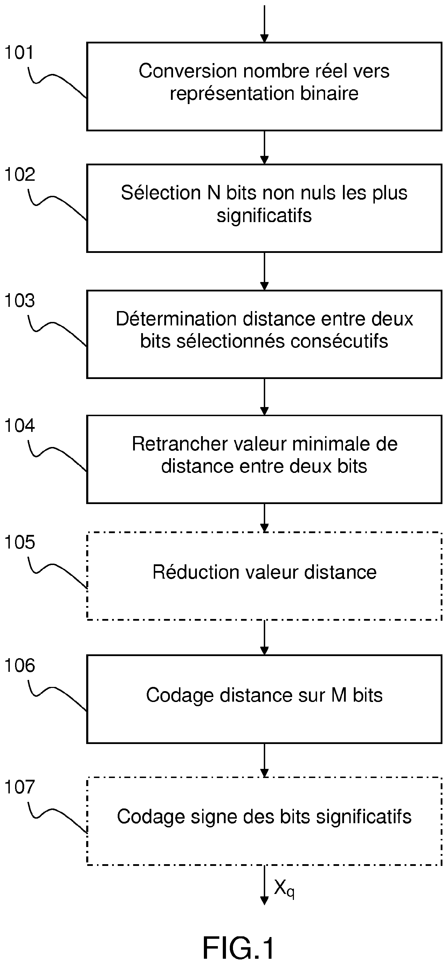

La figure 1 décrit les étapes de mise en œuvre du procédé de quantification selon l'invention qui vise à coder un nombre réel $X_f$ en un nombre quantifié $X_q$ avec un nombre limité de bits. On suppose que le nombre réel $X_f$ est compris strictement entre -1 et 1, autrement dit que la partie entière du nombre est nulle. Si le nombre à coder ne vérifie pas cette propriété, on opère au préalable une conversion du nombre dans l'intervalle ]-1 ; 1[. Cette opération peut être effectuée simplement en décalant la position de la virgule vers la gauche jusqu'à obtenir un nombre compris dans l'intervalle ]-1 ; 1[.

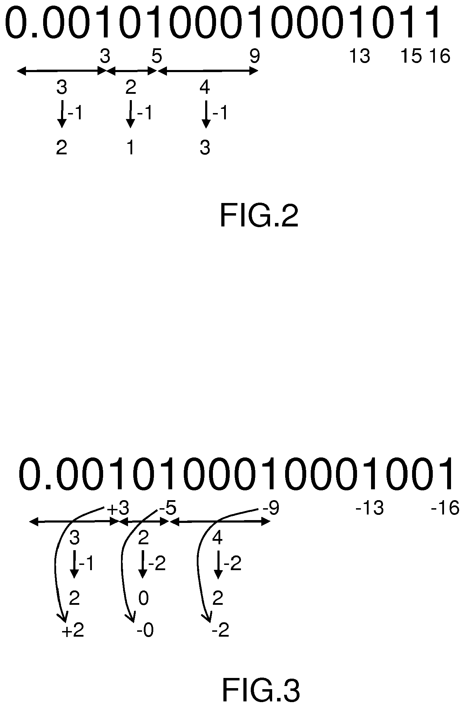

Dans une première étape 101, le nombre réel $X_f$ à coder est transformé dans une représentation binaire. Dans un premier mode de réalisation de l'invention, on choisit une représentation binaire, autrement dit une représentation en base deux. La figure 2 représente à titre illustratif la valeur binaire du nombre réel 0,158370972 quantifié sur 16 bits.

Dans une deuxième étape 102, on sélectionne, dans la partie fractionnaire de la représentation binaire du nombre, les N bits non nuls les plus significatifs et on retient leur position. Dans l'exemple de la figure 2, N est choisi égal à 3, le nombre est alors tronqué en ne conservant que les trois bits à 1 les plus significatifs ce qui donne la valeur binaire 0.001010001. Les positions de ces trois bits par rapport à la virgule sont données par le triplet {3 ; 5 ; 9}.

Dans une troisième étape 103, on calcule ensuite la distance entre deux positions successives. Dans l'exemple de la figure 2, la distance entre la virgule et le premier bit non nul est égale à 3-0 = 3, la distance entre le premier bit non nul et le deuxième bit non nul est égale à 5-3 = 2, la distance entre le deuxième bit non nul et le troisième bit non nul est égale à 9-5 = 4. On obtient donc le triplet de distances {3; 2; 4}.

Dans une quatrième étape 104, on retranche à chaque distance, la distance minimale entre deux bits consécutifs qui vaut 1 dans le cas d'une représentation binaire. En effet, la distance entre deux bits étant toujours au moins égale à 1, on peut retrancher cette valeur aux distances calculées. L'objectif de cette étape est de limiter autant que possible les valeurs de distances à des nombres petits et ce pour limiter le nombre de bits nécessaire pour les coder. Après l'étape 104, le triplet de distances modifiées est égal à {2; 1; 3}.

Dans une étape supplémentaire 106, les distances modifiées obtenues sont codées sur M bits, M étant choisi égal à la valeur maximale permettant de coder les distances modifiées obtenues. Dans l'exemple de la figure 2, M est égal à deux bits et le nombre quantifié obtenu par le procédé selon l'invention est donné par le triplet {10; 01 ; 11}.

Il convient de noter cependant que le nombre M choisi peut être différent pour chaque distance.

De façon plus générale, la correspondance entre un nombre réel $X_f$ et sa version quantifiée par application du procédé selon l'invention $X_q = \{P_1 ; P_2 ;... ; P_N\}$ est donnée par la relation suivante :

$$X_q = \{P_1 ; P_2 ;... ; P_N\} \sim X_f = \sum_{i=1}^{N} 2^{-(\sum_{j=1}^{i} P_j + i)} \qquad (1)$$

La relation (1) permet de décoder le nombre quantifié $X_q$ pour retrouver le nombre réel correspondant $X_f$.

Un des avantages du procédé selon l'invention réside dans les faibles valeurs des distances obtenues à l'issue de l'étape 104 qui peuvent ainsi être codées sur un nombre réduit de bits. Dans l'exemple donné à la figure 2, les distances obtenues sont au plus égales à trois, ce qui permet un codage sur deux bits.

Cependant, un problème se pose si une ou plusieurs distances présentent une valeur qui dépasse la valeur maximale admissible pour un codage sur M bits, autrement dit qui dépasse la valeur $2^M$-1.

Pour résoudre ce problème, une étape supplémentaire optionnelle 105 peut être ajoutée au procédé avant la quantification des distances.

Un exemple de cas problématique correspond au nombre 0.0100000101010011 en représentation binaire qui peut être codé par les distances {1 ; 5; 1}. La distance 5 ne peut pas être codée sur deux bits. Pour pallier ce problème, les valeurs qui dépassent la valeur maximale $2^M$-1, avec M le nombre de bits choisi pour la distance à coder, sont décomposées en une somme de valeurs inférieures à cette valeur maximale. Dans l'exemple ci-dessus, la distance 5 peut être décomposée en une somme 5=3+2..

Par ce processus, on décompose une distance ayant une valeur élevée en plusieurs sous-distances qui sont codées individuellement.

On introduit ensuite la notion de distance inactive et de distance active. Une distance est dite inactive si sa valeur est égale à $2^M$-1 en notation réelle ou si tous ses bits sont égaux à 1 en notation binaire. Si cela est le cas, lors du décodage du nombre quantifié, cette distance est sauvegardée et additionnée à la distance suivante. Cette action est itérée jusqu'à la lecture d'une distance active dont la valeur est strictement inférieure à $2^M$-1.

Dans l'exemple précité, le nombre quantifié obtenu est donné par le triplet {01 ; 11 ; 10} qui correspond en valeurs réelles aux distances {1 ; 3; 2} et en sommant la distance inactive 3 avec la distance active suivante 2 on obtient le doublet de distances {1 ;5} qui représente le nombre 0.01000001. Dans l'exemple précédent le nombre M de bits choisi pour coder chaque distance est le même mais il peut également être pris égal à une valeur différente pour chaque distance.

Plus généralement, le processus de codage peut être décrit de la façon suivante.

Soit $\{M_1 ;... ; M_N\}$ les nombres de bits choisis pour coder respectivement les distances $\{P_1 ; P_2 ;... ; P_N\}$. Si une distance $P_i$ a une valeur qui dépasse la valeur maximale $2^{M_i}$-1, alors elle est décomposée en $P_i = P'_i + P'_{i+1}$, avec $P'_i = 2^{M_i}$-1 qui est codée en distance inactive. On opère ensuite les substitutions suivantes $P_N = P_{N-1}$, ..., $P_{i+2} = P_{i+1}$, $P_{i+1} = P'_{i+1}$, puis on poursuit le processus de codage avec la distance suivante $P_{i+1}$ qui est la distance suivante qui est codée avec $M_{i+1}$ bits.

La relation (1) est alors modifiée en la relation (2) suivante :

$$Xq = \{P_1 ; P_2 ; \dots ; P_N\} \sim Xf = \sum_{i=1}^{N} A_i . 2^{-\sum_{j=1}^{i}(P_j + A_j)} \qquad (2)$$

Ai définit si la distance i est active: si tous les bits de la distance Pi valent 1, Ai = 0, autrement, Ai = 1. Quand Ai = 1, le signe de Si avant chaque position indique si on ajoute ou soustrait la puissance de 2 de cette position à la valeur finale. Ai représente le facteur de distance et vaut 1 pour une distance active et 0 pour une distance inactive.

La relation (2) permet de décoder le nombre quantifié $X_q$ pour retrouver le nombre réel correspondant $X_f$.

Un problème supplémentaire se pose lorsqu'on applique le procédé de codage selon l'invention tel que décrit ci-dessus à un nombre dont la représentation binaire comporte un grand nombre de 1 consécutifs dans sa partie fractionnaire. Par exemple, le nombre 0.0111101110111011 est approximé par 0.0111 si on ne sélectionne que N=3 bits non nuls significatifs. On voit que dans cet exemple, l'erreur de quantification est importante.

Une solution pour limiter l'erreur de quantification consiste à utiliser non pas une représentation binaire mais une représentation ternaire (-1, 0, 1) connue sous l'appellation mathématique de représentation ternaire balancée. En effet, en utilisant en plus de l'addition, l'opération de soustraction, le nombre 0.0111101110111011 peut être approximé par la somme signée des trois puissances de deux suivantes : $2^{-1} - 2^{-6} - 2^{-10}$. En utilisant cette approximation, l'erreur de quantification résultante est moins importante que dans le cas de la représentation binaire: $2^{-2} + 2^{-3} + 2^{-4}$.

Lorsqu'une représentation ternaire balancée est utilisée, il faut, en plus des distances entre bits non nuls significatifs, coder le signe associé à chaque bit non nul. Ainsi, dans une ultime étape 107, on code sur un bit ce signe.

La relation de correspondance (2) devient alors :

$$Xq = \{S_1 P_1 ; S_2 P_2 ; \dots ; S_N P_N\} \sim Xf = \sum_{i=1}^{N} A_i . (-1)^{S_i} . 2^{-(\sum_{j=1}^{i}(P_j + A_j)))} \qquad (3)$$

$S_i$ est la valeur codée du signe qui vaut 0 si le signe de la $i^{ème}$ position du bit non nul dans la décomposition ternaire balancée est positif et 1 si ce signe est négatif.

L'utilisation d'une représentation ternaire balancée présente cependant l'inconvénient d'une absence d'unicité de cette représentation. Autrement dit, un même nombre peut avoir plusieurs représentations ternaires balancées. Cette absence d'unicité pose problème dans la mesure où certaines occurrences de cette représentation peuvent engendrer une erreur de quantification encore plus importante que pour une représentation binaire..

Pour cette raison, et selon un second mode de réalisation, le procédé selon l'invention peut être également appliqué à une représentation binaire canonique signée ou « Canonical Signed Digit » CSD en anglais.

Cette représentation est introduite dans la référence [4]. Elle utilise un système de nombres ternaires {1',0,1} où 1' représente la valeur -1. La représentation CSD consiste en une somme de puissances de deux signées tout comme la représentation en base deux signée. Elle possède cependant les propriétés suivantes qui la différencie de la représentation en base deux signée :

- Deux bits consécutifs ne peuvent être non nuls,
- La représentation CSD est unique,
- La représentation CSD comporte un nombre minimum de bits non nuls.

Ainsi, dans la représentation CSD d'un nombre, seulement un tiers des bits sont non nuls en moyenne contre la moitié dans une représentation binaire classique.

Cette propriété de la représentation CSD est avantageuse pour l'invention puisqu'un objectif du procédé de codage envisagé est de coder les distances entre bits non nuls. Plus le nombre de bits non nuls est faible, plus cela signifie que la précision du nombre quantifié sera importante car le nombre de bits non nuls tronqués sera limité.

La figure 3 donne à titre illustratif la représentation CSD du nombre 0.091903687. Cette représentation binaire comporte cinq bits non nuls aux positions {3; 5; 9; 13; 16} et les signes associés à ces bits sont {+; -; -; +; -}.

Le procédé selon l'invention est appliqué à cette représentation binaire CSD de la même façon que celle décrite à la figure 1. La seule différence réside dans le fait que la distance minimale entre deux bits non nuls, dans une représentation CSD, est égale à deux et non plus à un. Dans l'étape 104 du procédé, on retranche alors à chaque distance calculée la valeur 2 au lieu de la valeur 1 dans le cas de la représentation binaire..

En revenant à l'exemple précité, on retient les trois bits non nuls les plus significatifs et leurs positions {3; 5; 9} ainsi que leurs signes {+; -; -}. On calcule alors les distances entre deux bits non nuls significatifs consécutifs {3-0; 5-3; 9-5}={3; 2; 4}. On retranche ensuite à ces valeurs la distance minimale égale à 2 pour obtenir le triplet {1 ; 0; 2}. En ajoutant les signes, on arrive au résultat {+1 ; -0; -2}.

La relation de correspondance (3) est modifiée dans le cas d'une représentation binaire canonique signée en la relation (4) suivante :

$$Xq = \{S_1 P_1 ; S_2 P_2 ; ... ; S_N P_N\} \sim Xf = \sum_{i=1}^{N} A_i . (-1)^{S_i} . 2^{1-(\sum_{j=1}^{i}(P_j + 2A_j))} \quad (4)$$

Le procédé selon l'invention peut être implémenté à partir d'éléments matériel et/ou logiciel. Il peut notamment être mis en œuvre en tant que programme d'ordinateur comportant des instructions pour son exécution. Le programme d'ordinateur peut être enregistré sur un support d'enregistrement lisible par un processeur.

Le procédé selon l'invention peut être exécuté par un processeur qui peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gate Array »).

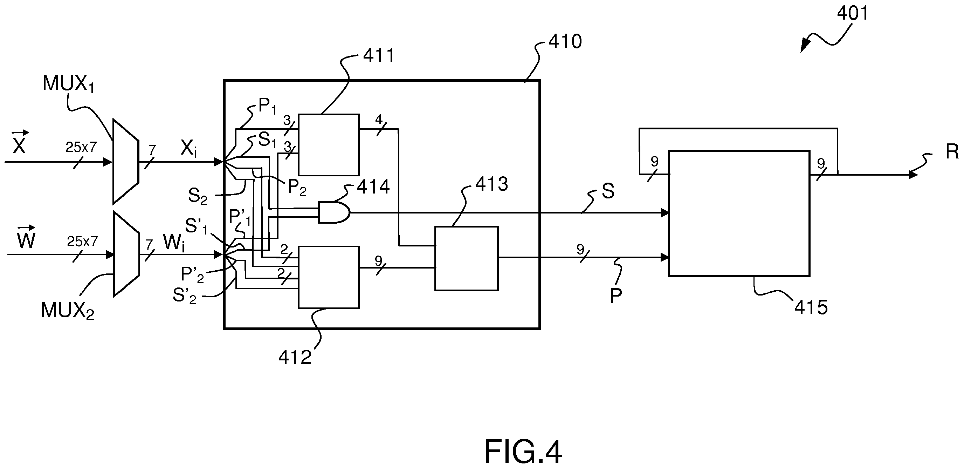

La figure 4 décrit un module de convolution 401 de deux vecteurs de nombres entiers quantifiés par application du procédé selon l'invention.

Le module 401 est décrit sous la forme d'un circuit intégré de type ASIC mais il peut également être implémenté par un circuit du type FPGA ou via toute autre implémentation adaptée.

Le module 401 est configuré pour réaliser la convolution d'un premier vecteur X comprenant, par exemple, 25 échantillons quantifiés $x_i$ et d'un second vecteur W comprenant également, par exemple, 25 échantillons quantifiés $w_i$.

Les échantillons $x_i$ du premier vecteur sont quantifiés par deux distances P1,P2 codées respectivement sur 3 et 2 bits et leurs signes associés S1,S2.

Les échantillons $w_i$ du second vecteur sont quantifiés avec les mêmes paramètres, autrement dit par deux distances P'1,P'2 codées également respectivement sur 3 et 2 bits et leurs signes associés S'1,S'2.

Chaque échantillon est donc quantifié sur 7 bits au total correspondant à 3 bits pour la première distance, 2 bits pour la seconde distance et 1 bit pour chacun des deux signes.

Les 25 échantillons de chaque vecteur sont produits en entrée de deux multiplexeurs MUX1,MUX2.

Le module 401 de convolution comprend également un premier sous-module 410 de multiplication ou multiplieur et un second sous-module 415 d'accumulation, ou accumulateur, des sorties du multiplieur 410.

Le multiplieur 410 réalise la multiplication de deux nombres $x_i,w_i$. Cette multiplication peut être décomposée de la façon suivante :

$$x_i * w_i = \left\{(-1)^{S_1} 2^{-(P_1+1)} + (-1)^{S_2} 2^{-(P_1+P_2+3)}\right\}$$

$$* \left\{(-1)^{S'_1} 2^{-(P'_1+1)} + (-1)^{S'_2} 2^{-(P'_1+P'_2+3)}\right\}$$

$$x_i * w_i = (-1)^{S_1} 2^{-(P_1+1)}\left\{1 + (-1)^{S_2} 2^{-(P_2+2)}\right\} * (-1)^{S'_1} 2^{-(P'_1+1)}\{1 +$$

$$-1^{S'_2} 2^{-P'_2+2}$$

$$x_i * w_i = (-1)^{S_1+S'_1} 2^{-(P_1+P'_1+2)} \Gamma(S_2, P_2, S'_2, P'_2) \quad (5)$$

La relation (5) permet d'optimiser l'implémentation du multiplieur 410 qui est ainsi composé :

- d'un additionneur 411 qui réalise l'addition sur 3 bits des distances $P_1$ et $P'_1$,
- d'une table 412 qui stocke les valeurs de la fonction $\Gamma(S_2, P_2, S'_2, P'_2)$ et qui a pour entrées les nombres $S_2, P_2, S'_2, P'_2$.
- d'une porte logique OU exclusif 414 qui délivre le signe du produit $x_i * w_i$ donné par la valeur $(-1)^{S_1+S'_1}$
- d'un registre à décalage 413 pour réaliser l'opération $2^{-(P_1+P'_1+2)}$

Le multiplieur 410 délivre le signe S et la valeur P du produit qui sont ensuite fournies en entrée de l'accumulateur 415 qui réalise la somme des 25 produits afin de produire le résultat R de la convolution.

Un avantage du module de convolution 401 et en particulier du multiplieur 410 est sa simplicité d'implémentation grâce à la quantification particulière réalisée selon l'invention sur les entrées.

Le module 401 permet un gain significatif en puissance consommée, en surface nécessaire et aussi en fréquence maximale de fonctionnement comparativement à un module de convolution réalisé avec une quantification classique des données sur 7 bits.

Ainsi, le module 401 de convolution selon l'invention peut être avantageusement utilisé pour toute application de traitement de données ou traitement de signal qui nécessite d'effectuer des multiplications ou des convolutions à un rythme important. En particulier, ce module peut être utilisé par un réseau de neurones pour calculer le nouvel état d'un neurone en réalisant la somme pondérée des entrées par les poids synaptiques.

Les paramètres de quantification des données peuvent être déterminés par optimisation, par exemple en simulant les performances de l'application visée en faisant varier le nombre de bits de quantification et/ou le nombre de distances conservées pour coder un nombre réel.

Dans le cas d'un réseau de neurones utilisé pour une application de reconnaissance de caractères, les paramètres de quantification peuvent être déterminés en observant le pourcentage de mauvaises classifications en fonction des paramètres utilisés et en conservant les paramètres qui offrent le meilleur compromis entre nombre de bits de quantification utilisés et précision requise sur les données pour conserver des performances acceptables pour l'application. Les résultats de simulations montrent un réel avantage en taille de mémoire de stockage des coefficients synaptiques et des données d'entrée du type de codage proposé par rapport à un codage binaire pour des résultats en précision similaire.

**Références**

[1] « Fast neural network implementation », Skrbek, M., Neural Network World, 9(5), 375-391, 1999.
[2] " Applicability of approximate multipliers in hardware neural networks", Lotric, U., Bulic, P., Neurocomputing, 96, 57-65, 2012.
[3] "Improving the speed of neural networks on CPUs", Vincent Vanhoucke et AI (https:// deeplearning works hopnips 2011. files.wordpress.com/2011/12/8.pdf), 17 décembre 2011.
[4] "Fractions in the canonical-signed-digit number system", J.O.Coleman and A.Yurdakul, 2001, In Conf. on information sciences and systems.

**Revendications**

1. Procédé, mis en œuvre par un processeur, de codage d'un signal réel, par exemple un signal image, en un signal quantifié, ledit procédé comprenant les étapes suivantes appliquées à chaque échantillon réel dudit signal réel :

   • Convertir (101) l'échantillon réel dans une représentation numérique en un échantillon binarisé comportant une partie fractionnaire,
   • Sélectionner (102), dans la partie fractionnaire du nombre, un nombre N prédéterminé de bits non nuls les plus significatifs,
   • pour chaque bit i significatif non nul sélectionné, i variant de 1 à N, déterminer (103) sa distance $P_i$ par rapport au bit significatif non nul sélectionné voisin de rang supérieur ou, pour le premier bit significatif non nul sélectionné, par rapport à la virgule,
   • retrancher (104) de ladite distance $P_i$ la plus petite valeur possible de distance entre deux bits non nuls dans un nombre quelconque binarisé converti dans ladite représentation numérique,
   • coder (106) la distance modifiée $P_i$ sur un nombre $M_i$ de bits prédéterminé.

2. Procédé de codage d'un signal réel en un signal quantifié selon la revendication 1 comprenant une étape préalable de transformation (101) de l'échantillon réel en un nombre réel compris strictement entre - 1 et 1.

3. Procédé de codage d'un signal réel en un signal quantifié selon l'une des revendications précédentes dans lequel la représentation numérique est une représentation binaire.

4. Procédé de codage d'un signal réel en un signal quantifié selon l'une des revendications 1 ou 2 dans lequel la représentation numérique est une représentation ternaire balancée dans laquelle un signe +/- est associé à chaque bit, ledit signe étant codé (107) par un bit dans le signal quantifié.

5. Procédé de codage d'un signal réel en un signal quantifié selon l'une des revendications 3 ou 4 dans lequel la valeur minimale de distance entre deux bits non nuls est égale à un.

6. Procédé de codage d'un signal réel en un signal quantifié selon l'une des revendications 1 ou 2 dans lequel la représentation numérique est une représentation binaire signée canonique qui vérifie les propriétés suivantes :

   • Deux bits consécutifs de la représentation binaire signée canonique d'un nombre ne sont jamais simultanément non nuls,
   • La représentation binaire signée canonique d'un nombre est unique,

• La représentation binaire signée canonique d'un nombre comporte un nombre minimum de bits non nuls.

7. Procédé de codage d'un signal réel en un signal quantifié selon la revendication 6 dans lequel la valeur minimale de distance entre deux bits non nuls est égale à deux.

8. Procédé de codage d'un signal réel en un signal quantifié selon l'une des revendications précédentes comprenant en outre les étapes suivantes (105) :

• Si la distance modifiée $P_i$, associée au bit significatif non nul d'indice i, présente une valeur supérieure ou égale à $2^{m_i} - 1$, où $M_i$ est le nombre de bits choisi pour coder la distance modifiée $P_i$, décomposer la valeur de la distance modifiée en une somme de $2^{M_i} - 1$ et d'une valeur résiduelle $P'_{i+1}$,
• Coder le terme $2^{M_i} - 1$ sur le nombre de bits $M_i$ choisi pour coder la distance modifiée $P_i$,
• Effectuer les substitutions suivantes : $P_N = P_{N-1}$, ..., $P_{i+2} = P_{i+1}$, $P_{i+1} = P'_{i+1}$

9. Procédé de codage d'un signal réel en un signal quantifié selon l'une des revendications précédentes dans lequel le signal est un signal image ou un signal composé de poids synaptiques d'un réseau de neurones.

10. Dispositif de codage d'un signal réel, par exemple un signal vidéo, en un signal quantifié, comprenant un module configuré pour exécuter le procédé selon l'une quelconque des revendications 1 à 9.

11. Programme d'ordinateur comportant des instructions pour l'exécution du procédé de codage d'un signal réel par exemple un signal vidéo, en un signal quantifié, selon l'une quelconque des revendications 1 à 9, lorsque le programme est exécuté par un processeur.

12. Circuit multiplieur (410) configuré pour calculer le résultat de la multiplication d'un premier nombre ($x_i$) avec un second nombre ($w_i$) quantifiés par application du procédé de codage selon l'une quelconque des revendications 1 à 9 avec un nombre N de distances égal à deux, ledit circuit (410) comprenant un additionneur (411) agencé pour additionner la première distance du premier nombre ($x_i$) quantifié avec la première distance du second nombre ($w_i$) quantifié, une table de correspondance (412) indexée au moins par les valeurs de la seconde distance du premier nombre ($x_i$) quantifié et de la seconde distance du second nombre ($w_i$) quantifié et un registre à décalage (413) configuré pour réaliser un décalage binaire sur la sortie de la table de correspondance (412) d'un nombre de bits égal à la sortie de l'additionneur (411).

13. Circuit multiplieur (410) selon la revendication 12 dans lequel la table de correspondance (412) est en outre indexée par le signe de la seconde distance du premier nombre quantifié ($x_i$) et le signe de la seconde distance du second nombre quantifié ($w_i$), ledit circuit multiplieur comprenant en outre une porte logique OU exclusif (414) recevant en entrée le signe de la première distance du premier nombre quantifié ($x_i$) et le signe de la première distance du second nombre quantifié ($w_i$).

14. Circuit de convolution (401) configuré pour calculer le résultat de la convolution entre un premier vecteur de nombres ($x_i$) et un second vecteur de nombres ($w_i$) quantifiés par application du procédé de codage selon l'une quelconque des revendications 1 à 9, ledit circuit de convolution (401) comprenant un circuit multiplieur (410) selon l'une des revendications 12 ou 13 et un accumulateur (415) configuré pour accumuler les valeurs de sortie du circuit multiplieur (410).

**Patentansprüche**

1. Verfahren, durchgeführt von einem Prozessor, zum Codieren eines realen Signals, zum Beispiel eines Bildsignals, in ein quantifiziertes Signal, wobei das Verfahren die folgenden auf jedes reale Sample des realen Signals angewendeten Schritte beinhaltet:

• Umwandeln (101) des realen Sample in einer digitalen Darstellung in ein binarisiertes Sample, das einen fraktionären Teil beinhaltet,
• Auswählen (102), in dem fraktionären Teil der Zahl, einer vorbestimmten Anzahl N der höchstwertigen Bits von ungleich null,
• Bestimmen (103), für jedes gewählte signifikante Bit i von ungleich null, wobei i von 1 bis N variiert, seiner Distanz $P_i$ in Bezug auf das gewählte signifikante Nachbarbit von ungleich null mit einem höheren Rang oder, für das erste gewählte signifikante Bit von ungleich null, in Bezug auf das Komma,
• Subtrahieren (104) von der Distanz $P_i$, des kleinstmöglichen Distanzwertes zwischen zwei Bits von ungleich null in einer beliebigen umgewandelten binarisierten Zahl in der digitalen Darstellung,
• Codieren (106) der modifizierten Distanz $P_i$ in eine vorbestimmte Anzahl $M_i$ von Bits.

2.  Verfahren zum Codieren eines realen Signals in ein quantifiziertes Signal nach Anspruch 1, das einen Vorabschritt des Transformierens (101) des realen Sample in eine reale Zahl strikt zwischen -1 und 1 beinhaltet.

3.  Verfahren zum Codieren eines realen Signals in ein quantifiziertes Signal nach einem der vorherigen Ansprüche, wobei die digitale Darstellung eine binäre Darstellung ist.

4.  Verfahren zum Codieren eines realen Signals in ein quantifiziertes Signal nach Anspruch 1 oder 2, bei dem die digitale Darstellung eine ternäre ausgewogene Darstellung ist, in der ein Vorzeichen +/- mit jedem Bit assoziiert ist, wobei das Vorzeichen durch ein Bit in dem quantifizierten Signal codiert (107) wird.

5.  Verfahren zum Codieren eines realen Signals in ein quantifiziertes Signal nach Anspruch 3 oder 4, wobei der Mindestdistanzwert zwischen zwei Bits von ungleich null gleich eins ist.

6.  Verfahren zum Codieren eines realen Signals in ein quantifiziertes Signal nach Anspruch 1 oder 2, wobei die digitale Darstellung eine kanonisch signierte binäre Darstellung ist, die die folgenden Eigenschaften verifiziert:

    • zwei konsekutive Bits der kanonisch signierten binären Darstellung einer Zahl sind niemals gleichzeitig ungleich null,
    • die kanonisch signierte binäre Darstellung einer Zahl ist einmalig,
    • die kanonisch signierte binäre Darstellung einer Zahl umfasst eine Mindestanzahl von Bits von ungleich null.

7.  Verfahren zum Codieren eines realen Signals in ein quantifiziertes Signal nach Anspruch 6, wobei der Mindestdistanzwert zwischen zwei Bits von ungleich null gleich zwei ist.

8.  Verfahren zum Codieren eines realen Signals in ein quantifiziertes Signal nach einem der vorherigen Ansprüche, das ferner die folgenden Schritte (105) beinhaltet:

    • Zerlegen des Wertes der modifizierten Distanz in eine Summe von $2^{M_i} - 1$ und einen Restwert $P'_{i+1}$, wenn die modifizierte Distanz $P_i$, assoziiert mit dem signifikanten Bit von ungleich null von Index i, einen Wert gleich oder größer als $2^{M_i} - 1$ hat, wobei $M_i$ die gewählte Anzahl von Bits zum Codieren der modifizierten Distanz $P_i$ ist,
    • Codieren des Terms $2^{M_i} - 1$ in die gewählte Anzahl von Bits $M_i$ zum Codieren der modifizierten Distanz $P_i$,
    • Bewirken der folgenden Substitutionen: $P_N = P_{N-1}$, ..., $P_{i+2} = P_{i+1}$, $P_{i+1} = P'_{i+1}$.

9.  Verfahren zum Codieren eines realen Signals in ein quantifiziertes Signal nach einem der vorherigen Ansprüche, wobei das Signal ein Bildsignal oder ein zusammengesetztes Signal von synaptischen Gewichtungen eines neuronalen Netzwerks ist.

10. Gerät zum Codieren eines realen Signals, zum Beispiel eines Videosignals, in ein quantifiziertes Signal, umfassend ein Modul, das zum Durchführen des Verfahrens nach einem der Ansprüche 1 bis 9 konfiguriert ist.

11. Computerprogramm, das Befehle zum Ausführen des Verfahrens zum Decodieren eines realen Signals, zum Beispiel eines Videosignals, in ein quantifiziertes Signal nach einem der Ansprüche 1 bis 9 umfasst, wenn das Programm von einem Prozessor ausgeführt wird.

12. Multiplikatorschaltung (410), konfiguriert zum Berechnen des Ergebnisses der Multiplikation einer ersten Zahl ($x_i$) mit einer zweiten Zahl ($w_i$), quantifiziert durch Anwenden des Verfahrens zum Codieren nach einem der Ansprüche 1 bis 9 mit einer Anzahl N von Distanzen von gleich zwei, wobei die Schaltung (410) Folgendes umfasst: einen Addierer (411), ausgelegt zum Addieren der ersten Distanz der ersten quantifizierten Zahl ($x_i$) zu der ersten Distanz der zweiten quantifizierten Zahl ($w_i$), eine Korrespondenztabelle (412), indexiert wenigstens durch die Werte der zweiten Distanz der quantifizierten ersten Zahl ($x_i$) und der zweiten Distanz der quantifizierten zweiten Zahl ($w_i$), und ein Versatzregister (413), konfiguriert zum Realisieren eines binären Versatzes am Ausgang der Korrespondenztabelle (412) einer Bitzahl gleich dem Ausgang des Addierers (411).

**13.** Multiplikatorschaltung (410) nach Anspruch 12, in der die Korrespondenztabelle (412) ferner durch das Vorzeichen der zweiten Distanz der quantifizierten ersten Zahl ($x_i$) und das Vorzeichen der zweiten Distanz der quantifizierten zweiten Zahl ($w_i$) indexiert ist, wobei die Multiplikatorschaltung ferner einen Exklusiv-ODER-Logikport (414) umfasst, der am Eingang das Vorzeichen der ersten Distanz der quantifizierten ersten Zahl ($x_i$) und das Vorzeichen der ersten Distanz der quantifizierten zweiten Zahl ($w_i$) empfängt.

**14.** Faltungsschaltung (401), konfiguriert zum Berechnen des Ergebnisses der Faltung zwischen einem ersten Zahlenvektor ($x_i$) und einem zweiten Zahlenvektor ($w_i$), quantifiziert durch Anwenden des Verfahrens zum Codieren nach einem der Ansprüche 1 bis 9, wobei die Faltungsschaltung (401) eine Multiplikatorschaltung (410) nach einem der Ansprüche 12 oder 13 und einen Akkumulator (415) umfasst, konfiguriert zum Akkumulieren der Ausgangswerte der Multiplikatorschaltung (410).

**Claims**

**1.** A method, implemented by a processor, of coding a real signal, for example an image signal, into a quantized signal, said method comprising the following steps applied to each real sample of said real signal:

• converting (101) the real sample in a digital representation into a binarized sample comprising a fractional part,
• selecting (102), in the fractional part of the number, a predetermined number N of most significant non-zero bits,
• for each non-zero significant bit i selected, i varying from 1 to N, determining (103) its distance $P_i$ with respect to the neighboring selected non-zero significant bit of higher rank or, for the first non-zero significant bit selected, with respect to the decimal point,
• deducting (104) from said distance $P_i$ the smallest possible value of distance between two non-zero bits in any converted binarized number into said digital representation,
• coding (106) the modified distance $P_i$ on a predetermined number $M_i$ of bits.

**2.** The method of coding a real signal into a quantized signal as claimed in claim 1, comprising a prior step (101) of transforming the real sample into a real number lying strictly between - 1 and 1.

**3.** The method of coding a real signal into a quantized signal as claimed in one of the preceding claims, in which the digital representation is a binary representation.

**4.** The method of coding a real signal into a quantized signal as claimed in one of claims 1 or 2, in which the digital representation is a balanced ternary representation in which a +/- sign is associated with each bit, said sign being coded (107) by a bit in the quantized signal.

**5.** The method of coding a real signal into a quantized signal as claimed in one of claims 3 or 4, in which the minimum value of distance between two non-zero bits is equal to one.

**6.** The method of coding a real signal into a quantized signal as claimed in one of claims 1 or 2, in which the digital representation is a canonical signed binary representation which satisfies the following properties:

• two consecutive bits of the canonical signed binary representation of a number are never simultaneously non-zero,
• the canonical signed binary representation of a number is unique,
• the canonical signed binary representation of a number comprises a minimum number of non-zero bits.

**7.** The method of coding a real signal into a quantized signal as claimed in claim 6, in which the minimum value of distance between two non-zero bits is equal to two.

**8.** The method of coding a real signal into a quantized signal as claimed in one of the preceding claims, furthermore comprising the following steps (105):

• decomposing the value of the modified distance into a sum of $2^{M_i} - 1$ and of a residual value $P'_{i+1}$ if the modified distance $P_i$, associated with the non-zero significant bit of index i, exhibits a value greater than or equal to $2^{M_i} - 1$, where $M_i$ is the number of bits chosen to code the modified distance $P_i$,
• coding the term $2^{M_i} - 1$ on the number of bits $M_i$ chosen to code the modified distance $P_i$,

• performing the following substitutions: $P_N = P_{N-1}, ..., P_{i+2} = P_{i+1}, P_{i+1} = P'_{i+1}$

9. The method of coding a real signal into a signal quantized according to one of the preceding claims, in which the signal is an image signal or a signal composed of synaptic weights of a neural network.

10. A device for coding a real signal, for example a video signal, into a quantized signal, comprising a module configured to execute the method as claimed in any one of claims 1 to 9.

11. A computer program comprising instructions for the execution of the method of coding a real signal, for example a video signal, into a quantized signal, as claimed in any one of claims 1 to 9, when the program is executed by a processor.

12. A multiplier circuit (410) configured to calculate the result of multiplying a first number $(x_i)$ by a second number $(w_i)$, both of which are quantized by applying the method of coding as claimed in any one of claims 1 to 9 with a number N of distances, equal to two, said circuit (410) comprising an adder (411) designed to add together the first distance of the first quantized number $(x_i)$ and the first distance of the second quantized number $(w_i)$, a correspondence table (412) indexed at least by the values of the second distance of the first quantized number $(x_i)$ and of the second distance of the second quantized number $(w_i)$ and a shift register (413) configured to carry out a binary shift on the output of the correspondence table (412) of a number of bits equal to the output of the adder (411).

13. The multiplier circuit (410) as claimed in claim 12, in which the correspondence table (412) is furthermore indexed by the sign of the second distance of the first quantized number $(x_i)$ and the sign of the second distance of the second quantized number $(w_i)$, said multiplier circuit furthermore comprising an exclusive OR logic gate (414) receiving as input the sign of the first distance of the first quantized number $(x_i)$ and the sign of the first distance of the second quantized number (wi).

14. A convolution circuit (401) configured to calculate the result of convolving a first vector of numbers $(x_i)$ and a second vector of numbers $(w_i)$ quantized by applying the method of coding as claimed in any one of claims 1 to 9, said convolution circuit (401) comprising a multiplier circuit (410) as claimed in one of claims 12 or 13 and an accumulator (415) configured to accumulate the output values of the multiplier circuit (410).

101 Conversion nombre réel vers représentation binaire

102 Sélection N bits non nuls les plus significatifs

103 Détermination distance entre deux bits sélectionnés consécutifs

104 Retrancher valeur minimale de distance entre deux bits

105 Réduction valeur distance

106 Codage distance sur M bits

107 Codage signe des bits significatifs

$X_q$

FIG.1

0.00101000**1**0001011

3  5  9  13  15 16

3  2  4

↓-1  ↓-1  ↓-1

2  1  3

FIG.2

0.00101000**1**0001001

+3  -5  -9  -13  -16

3  2  4

↓-1  ↓-2  ↓-2

2  0  2

+2  -0  -2

FIG.3

FIG.4

EP 3 202 044 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **SKRBEK, M.** Fast neural network implementation. *Neural Network World,* 1999, vol. 9 (5), 375-391
- **LOTRIC, U. ; BULIC, P.** Applicability of approximate multipliers in hardware neural networks. *Neurocomputing,* 2012, vol. 96, 57-65
- **VINCENT VANHOUCKE.** *Improving the speed of neural networks on CPUs,* 17 Décembre 2011, https:// deeplearning works hopnips 2011. files.wordpress.com/2011/12/8.pdf
- **J.O.COLEMAN ; A.YURDAKUL.** Fractions in the canonical-signed-digit number system. *In Conf. on information sciences and systems,* 2001